# EUROPÄISCHE PATENTSCHRIFT

(11) **EP 0 570 819 B1**
(45) Veröffentlichungstag und Bekanntmachung des Hinweises auf die Patenterteilung: **10.12.1997**
(21) Anmeldenummer: 93107687.1
(22) Anmeldetag: 11.05.1993
(51) Int. Cl.: H03L 7/189, H03L 7/107

(54) **Verfahren zum Einstellen von PLL-Parametern**
Method for controlling the parameters of A PLL
Procédé pour contrôler les paramètres d'une boucle à verrouillage de phase

(30) Priorität: 20.05.1992 DE 4216714
(43) Veröffentlichungstag der Anmeldung: 24.11.1993
(73) Patentinhaber: SIEMENS AKTIENGESELLSCHAFT, 80333 München (DE)
(72) Erfinder: Greiderer, Reinhard, D-80803 München (DE)

(56) Entgegenhaltungen:
- EP-A- 0 482 823
- US-A- 4 885 554
- US-A- 4 926 141
- US-A- 4 980 653

## Beschreibung

Die Erfindung betrifft ein Verfahren zum Einstellen von PLL-Parametern in einer Anordnung mit mindestens zwei Frequenzteilern, deren Ausgangssignale in einem Phasendetector verglichen werden.

Solche Anordnungen sind u.a. aus dem ins Englische übersetzten Artikel "New CMOS PLL Component for Use in Mobile Radios in the 900 MHz Range" von G. Krings, H.-U. Irmer und R. Greiderer, Nachdruck aus "Nachrichtentechnische Zeitschrift (1988), Band 41, Heft 1, Seiten 24 bis 28 sowie aus dem kommerziell erhältlichen integrierten Schaltkreis mit der Bezeichenung TBB 206 bzw. dem Datenbuch der Firma Siemens, "ICs for Radio Equipment 1989/90", Seiten 51 bis 72, insbesondere Seite 71 in Verbindung mit Seite 54, bekannt.

Bei solchen Anordnungen treten beim ersten Einschalten und ebenso beim Ändern der Frequenz, dem sog. Kanalwechsel, Einschwingvorgänge auf. Während dieser Einschwingvorgänge stellt die Anordnung an ihrem Ausgang nicht das gewünschte Signal bereit. Insbesondere bei einem Kanalwechsel aus einem eingerasteten Zustand ist die Größe des durch den Kanalwechsel erzeugten Ausrastzustandes für den neuen Einschwingvorgang von Bedeutung.

Diesem Problem wurde bei dem kommerziellen Schaltkreis TBB 206 durch eine sogenannte "synchrone Programmierung" (siehe Seite 61 des o.g. Datenbuches) entgegengewirkt. Hierdurch werden beim programmgesteuerten Ändern der Teilerverhältnisse und somit der Ausgangsfrequenz der PLL die neuen Teilerverhältnisse unter Beibehaltung der zum Programmierzeitpunkt (Änderungszeitpunkt) bestehenden Phasendifferenz eingestellt. Das wird dadurch erreicht, daß die seriell eingelesenen zu ändernden Teilerverhältnisse in sogenannten Schattenregistern zwischengespeichert werden und diese zwischengespeicherten Teilerverhältnisse, nachdem beide Schattenregister geschrieben sind und der nächstfolgende Phasenvergleich im Phasendetector durchgeführt wird, so gleichzeitig in das jeweilige Datenregister des entsprechenden Teilers übernommen werden, daß beide Teiler zum Zeitpunkt des nächstfolgenden Phasenvergleiches auf die neuen Teilerverhältnisse eingestellt sind. Auch wenn nur das Teilerverhältnis eines Teilers verändert wird, erfolgt die Übernahme des neuen Teilerverhältnisses synchron zur bestehenden Phasendifferenz. Die Teiler sind üblicherweise als Zähler mit einem Datenregister realisiert, die von dem im Datenregister enthaltenen Wert - dem Teilerverhältnis - auf Null abwärts zählen und darauffoldend jeweils wieder auf den im Datenregister enthaltenen Wert gesetzt werden. Wenn demzufolge die neu einzustellenden Teilerverhältnisse beider Teiler in den jeweiligen Schattenregistern vorliegen, werden die beiden Zähler bzw. Teiler, jeweils nachdem sie auf Null gezählt haben, neu eingestellt, indem die Schattenregisterinhalte in die Datenregister der Teiler übernommen werden.

Bei dieser bekannten Anordnung werden die Ausgangsgrößen von zwei Teilern in einem Phasendetector verglichen. Die Ausgangsgröße dieses Phasendetectors wird über eine Ausgangsstufe, hier eine als Charge-Pump bezeichnete Stromquelle, an ein Schleifenfilter weitergeleitet. Die Ausgangsgröße dieser Ausgangsstufe ist unabhängig von der Ausgangsgröße des Phasendetectors zusätzlich durch eine weitere Größe veränderbar. Im vorliegenden Fall ist die Amplitude des Ausgangsstromes einer Stromquelle durch einen Steuerstrom eines Stromspiegels steuerbar. Durch Einflußnahme auf diese weitere, das Ausgangssignal des Phasendetectors beeinflußende Größe, kann ein Einschwingvorgang positiv beeinflußt werden. Die Ausgangsamplitude des Phasendetectors ist in der bekannten Anordnung durch Verändern eines Datenwortes veränderbar, so daß das Ausgangssignal des Phasendetectors programmgesteuert den jeweiligen Bedürfnissen angepaßt werden kann.

Aus dem Stand der Technik US 4 980 653 ist eine Nachlaufsynchronisation (phase locked loop) mit einem Sample-and-Hold-Phasendetector mit einstellbarer Verstärkung bekannt. Ein Schaltelement stellt die Anstiegsgeschwindigkeit des Phasendetectors entweder durch die Einfügung einer zusätzlichen Rampenkapazität im Phasendetector oder durch die Zunahme des Stroms zur Aufladung des Rampenkondensators ein.

Trotzdem ist der Verlauf der Einschwingvorgänge bei Kanalwechsel bei solchen bekannten Anordnungen insbesondere dann, wenn die PLL noch nicht eingerastet ist, nicht optimal.

Aufgabe der vorliegenden Erfindung ist es, ein Verfahren bereitzustellen, mit dessen Hilfe die Einschwingvorgänge insbesondere bei Kanalwechsel weiter optimiert werden können.

Diese Aufgabe wird gelöst durch ein Verfahren mit den Merkmalen des Patentanspruchs 1.

Bei einem erfindungsgemäßen Verfahren zum Einstellen von PLL-Parametern in einer PLL wird eine Änderung der Teilerverhältnisse der mindestens zwei Teiler synchron zur bestehenden Phasendifferenz durchgeführt und außerdem wird eine weitere, die Ausgangsgröße des Phasendetektors bestimmende Größe synchron verändert.

Synchron heißt hierbei, daß diese Größe möglichst früh nach dem Ändern der Teilerverhältnisse geändert ist. Hierbei ist anzustreben, daß der erste Ausgangsimpuls des Phasendetectors, der nach dem Ändern der Teilerverhältnisse ausgegeben wird, bereits mit der geänderten weiteren Größe beeinflußt ist.

Als Ausgangsstufe des Phasendetectors ist in einer Ausgestaltungsform einer PLL-Anordnung eine Stromquelle vorgesehen, wobei die Phasendifferenz am Eingang des Phasendetectors die Impulsdauer des Ausgangstromes dieser Stromquelle bestimmt und die Amplitude des Ausgangsstromes dieser Stromquelle in Abhängigkeit von einer Steuergröße einstellbar ist. Diese Steuergröße zum Einstellen der Stromamplitude kann in einer Ausgestaltungsform einer PLL-Anordnung durch Digital-Analog-Umsetzung eines Datenwortes erzeugt werden. Als Steuergröße bzw. als das Ausgangssignal des Phasendetectors beeinflussende weitere Größe kann hierbei bei Verwendung einer Stromspiegelschaltung ein Steuerstrom vorgesehen sein.

Nachstehend wird die Erfindung anhand der Figur näher erläutert.

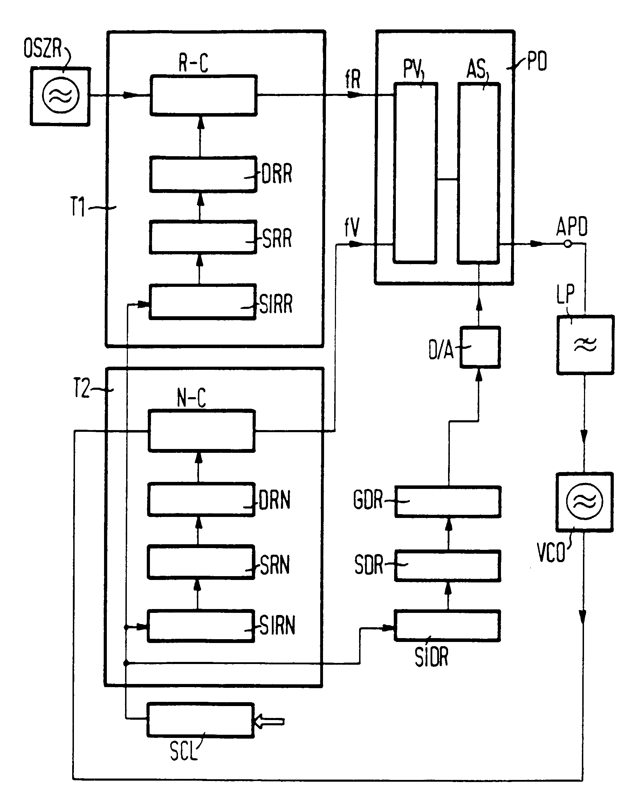

Figur 1 zeigt in vereinfachter Darstellung eine PLL, bestehend aus einem Referenzoszillator OSZR, der ein Referenzsignal bereitstellt und aus einem Oszillator VCO, dessen Frequenz spannungsabhängig steuerbar ist. Das Ausgangssignal des Referenzoszillators dient als Eingangssignal einer ersten Teilerschaltung T1, die in der dargestellten Ausführungsform aus einem Zähler R-C besteht, der von einem bestimmten Wert bis auf Null abwärts zählt sowie aus einem Datenregister DRR, in dem der entsprechende Teilerwert, von dem der Zähler abwärts zählt, abgelegt ist und vom Zähler nach Erreichen der Null jeweils gelesen wird. Das Datenregister DRR wird von einem Schattenregister SRR geladen, das wiederum taktgesteuert aus einem Schieberegister SIRR geladen werden kann. Am Ausgang des Zählers R-C und somit am Ausgang des Teilers T1 wird eine Frequenz fR bereitgestellt, die von der Referenzfrequenz des Oszillators OSZR und dem programmierten Teilerwert abhängt. Der zweite Teiler T2 enthält ebenfalls einen Zähler N-C sowie die entsprechenden Datenregister DRn, Schattenregister SRN und Schieberegister SIRN. Der Eingang des Zählers N-C wird mit dem Ausgangssignal des Oszillators VCO beaufschlagt und der Zähler stellt an seinem Ausgang ein Signal FV bereit, das von dem Ausgangssignal des VCO abhängt.

Die Anordnung enthält eine serielle Steuerlogik SCL, die über einen seriellen Bus Daten von einer nicht dargestellten Prozessoreinheit empfangen kann. Die serielle Steuerlogik SCL ordnet diese Daten den entsprechenden Schieberegister SIRR oder SIRN und ggf. anderen Schieberegistern zu. Die Ausgänge der Teiler T1 und T2 sind mit entsprechenden Eingängen einer Phasendetectoranordnung PD verbunden, die aus einem Phasendetector PV und einer Ausgangsstufe AS besteht. Der Phasendetector PV stellt an seinem Ausgang in Abhängigkeit von den an seinen Eingängen anliegenden Signalen fR und fV einen Logikpegel bereit und die Amplitude dieses Pegels ist über einen Steuereingang der Ausgangsstufe AS veränderbar. In dem dargestellten Ausführungsbeispiel wird die Ausgangsstufe AS von einem Datenregister GDR über eine Digital-Analogwandlung D/A angesteuert. Das am Ausgang APD der Phasendetectoranordnung bereitgestellte Signal ist somit sowohl von den Signalen fR und FV als auch von dem Inhalt des Datenregisters GDR abhängig. Das am Ausgang APD der Phasendetectoranordnung anstehende Signal wird über ein Regelfilter LP als Steuergröße an den Oszillator VCO geschaltet. Das Datenregister GDR ist über die serielle Steuerlogik SCL über ein Schieberegister SIDR und ein diesem nachgeschaltetes Schattenregister SDR programmierbar.

Erhält die serielle Steuerlogik SCL neue Teilerverhältnisse sowie eine neue Steuergröße für die Ausgangsstufe AS der Phasendetectoranordnung, so schreibt sie diese nacheinander in die Schieberegister SIRR, SIRN sowie in das Schieberegister SIDR. Der Inhalt der Schieberegisters SIRR wird in das Schattenregister SRR übernommen, der Inhalt des Schieberegisters SIRN wird in das Schattenregister SRN übernommen und der Inhalt des Schieberegisters SIDR wird in das Schattenregister SDR übernommen. Wenn alle Schattenregister programmiert worden sind, wird, nachdem der Zähler N-C des zweiten Teilers T2 auf Null gezählt und aus dem Datenregister den noch unveränderten Teilerwert entnommen hat, der Inhalt des Schattenregisters SRN des Teilers T2 in das Datenregister DRN übernommen. Außerdem wird ab dem genannten Zeitpunkt sobald der Zähler R-C des ersten Teilers T1 auf Null gezählt hat und den noch unveränderten Teilerwert aus dem Datenregister DRR übernommen hat, der Inhalt des Schattenregisters SRR in das Datenregister DRR übernommen. Frühestens nachdem in diesem Zyklus der Zähler R-C auf Null gezählt hatte und spätestens bevor der Zähler N-C wieder auf Null zählt, wird der Inhalt des Schattenregisters SDR in das Datenregister GDR übernommen, so daß zum nächstfolgenden Phasenvergleich ein neuer Wert für die die Amplitude des Ausgangssignales am Ausgang APD der Phasendetectoranordnung PD bestimmende Größe wirksam ist. Hierdurch wird ein synchrones Verändern der durch den Inhalt des Datenregisters GDR beeinflußten Größe in dem Sinne bewirkt, daß diese nach erfolgter Änderung der Teilerverhältnisse so rechtzeitig verändert worden ist, daß beim Erfassen der nächsten Phasendifferenz durch den Phasendetector PV der neue Wert eingestellt ist.

## Patentansprüche

1. Verfahren zum Einstellen von PLL-Parametern in einer PLL mit mindestens zwei Teilern (T1, T2), deren Ausgangssignale (fR, fV) in einem Phasendetector (PD) mit Ausgangsstufe (As) verglichen werden und die Ausgangsgröße dieser Ausgangsstufe (As) sowohl von der Phasendifferenz am Eingang des Phasendetectors (PD) abhängt als auch durch eine weitere elektrische Steuergröße beeinflußbar ist, wobei eine Änderung der Teilerverhältnisse der mindestens zwei Teiler (T1, T2) synchron zur bestehenden Phasendifferenz erfolgt,
**dadurch gekennzeichnet,**
daß bei einer Änderung der Teilerverhältnisse außerdem die weitere, die Ausgangsgröße des Phasendetectors (PD) bestimmende Steuergröße synchron zum nächstfolgenden Phasenvergleich veränderbar ist,
daß als Ausgangsstufe (As) des Phasendetectors (PD) eine Stromquelle vorgesehen ist, wobei die Phasendifferenz am Eingang des Phasendetectors (PD) die Impulsdauer des Ausgangsstromes dieser Stromquelle bestimmt und die Amplitude des Ausgangsstromes dieser Stromquelle in Abhängigkeit von der Steuergröße einstellbar ist,
daß diese Steuergröße zum Einstellen der Stromamplitude durch Digital-Analog-Umsetzung eines Datenwortes erzeugt wird.

## Claims

1. Method for setting PLL parameters in a PLL having at least two dividers (T1, T2) whose output signals (fR, fV) are compared in a phase detector (PD) having output stage (As), and the output quantity of this output stage (As) is both dependent on the phase difference at the input of the phase detector (PD) and can be influenced by a further electrical control quantity, a change in the division ratio of the at least two dividers (T1, T2) taking place synchronously with the existing phase difference, characterized in that, in the event of a change in the division ratio, the further control quantity, which determines the output quantity of the phase detector (PD), can furthermore be changed synchronously with the subsequent phase comparison, in that a current source is provided as output stage (As) of the phase detector (PD), the phase difference at the input of the phase detector (PD) determining the pulse duration of the output current of this current source, and the amplitude of the output current of this output source being adjustable as a function of the control quantity, and in that this control quantity for adjusting the current amplitude is produced by digital/analogue conversion of a data word.

## Revendications

1. Procédé pour régler les paramètres d'une boucle à verrouillage de phase avec au moins deux diviseurs (T1, T2) dont les signaux de sortie (fR, fV) sont comparés dans un détecteur de phase (PD) comportant une sortie (As), et la grandeur de sortie de cette sortie (As) dépend non seulement de la différence de phase à l'entrée du détecteur de phase (PD) mais est aussi influençable par une autre grandeur de commande, une modification des rapports des au moins deux diviseurs (T1, T2) s'effectuant de manière synchrone à la différence de phase existante, caractérisé en ce que l'autre grandeur de commande déterminant la grandeur de sortie du détecteur de phase (PD) peut elle aussi être modifiée de manière synchrone à la comparaison de phase suivante lorsque les rapports diviseurs sont modifiés, en ce qu'une source de courant est prévue comme sortie (As) du comparateur de phase (PD), la différence de phase à l'entrée du détecteur de phase (PD) déterminant la durée d'impulsion du courant de sortie de cette source de courant et l'amplitude du courant de sortie de cette source de courant pouvant être réglée en fonction de la grandeur de commande, et en ce que cette grandeur de commande pour régler l'amplitude de courant est générée par conversion numérique-analogique d'une zone de données.
